# EUROPEAN PATENT APPLICATION

(11) **EP 4 685 837 A1**
(43) Date of publication of application: **28.01.2026**
(21) Application number: 24190998.5
(22) Date of filing: 25.07.2024
(51) Int. Cl.: H01J 37/12, H01J 37/28

(54) **CHARGED PARTICLE-OPTICAL ELEMENT, CHARGED PARTICLE-OPTICAL DEVICE AND METHODS OF MANUFACTURING ELECTRODES**

(71) Applicant: ASML Netherlands B.V., 5500 AH Veldhoven (NL)
(72) Inventor: VEENSTRA, Roy, Ramon, 5500 AH Veldhoven (NL); MUDRETSOV, Dmitry, 5500 AH Veldhoven (NL); STEGEMANN, Almut, Johanna, 5500 AH Veldhoven (NL); KRECINIC, Faruk, 5500 AH Veldhoven (NL); KUIPER, Vincent, Sylvester, 5500 AH Veldhoven (NL)
(74) Representative: ASML Netherlands B.V.

(57) **Abstract**

A charged particle-optical element comprising a first electrode and a second electrode, each having a plurality of apertures configured and arranged for passing individual beamlets of a beam grid array through the charged particle-optical element, wherein
the first electrode has a first electrode surface having a first curved region in which the plurality of apertures is formed, the first curved region being curved in two dimensions;
the second electrode has a second electrode surface having a second curved region in which the plurality of apertures is formed, the second curved region being curved in two dimensions;
the first curved region and second curved region face each other to form a gap having a substantially constant width; and
the second electrode has a third electrode surface on the opposite side to the second electrode surface and the third electrode surface is substantially planar.

## Description

### FIELD

The present invention relates to charged particle-optical elements, charged particle-optical devices (e.g. e-beam tools) using the charged particle-optical elements and methods of manufacturing electrodes for use in the charged particle-optical elements.

### BACKGROUND

During manufacturing processes of, for example, semiconductor integrated circuit (IC) chips or displays, undesired defects may occur on a substrate (e.g. wafer) or a mask. Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relate to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; such defect inspection may be referred to as inspection. The interaction products may contain charged particles which may be referred to as signal particles (e.g. signal electrons), such as secondary electrons and backscattered electrons, and may contain other interaction products, such as X-ray radiation.

In a charged particle optical device that directs a plurality of beams onto a target, the beams (which may sometimes be referred to as sub-beams) may be generated from a single source. In such an arrangement, the separate beams are initially diverging from each other and are desirably collimated, that is redirected so as to form a grid of parallel beams. A macro collimator in the form of a large electron-optics lens may be provided to redirect all the beams. Alternatively, a collimator array comprising a plurality of collimators, one per beam may be employed. A known collimator array comprises a pair of electrodes curved in the X-direction for collimating the beams in the X-direction and a pair of electrodes curved in the Y-direction for collimating the beams in the Y-direction. The curved electrodes are mechanically stressed to adopt the required curvature. Each of the electrodes has an array of apertures corresponding to the grid of beams. This known collimator is bulky and the required alignment of the different electrodes is complex to achieve.

### SUMMARY

An object of the invention is to provide an improved collimator for a grid of beams, desirably addressing at least one disadvantage of known collimator arrays.

According to an aspect of the invention there is provided a charged particle-optical element comprising a first electrode and a second electrode, each having a plurality of apertures configured and arranged for passing individual beamlets of a beam grid array through the charged particle-optical element, wherein
the first electrode has a first electrode surface having a first curved region in which the plurality of apertures is formed, the first curved region being curved in two dimensions;
the second electrode has a second electrode surface having a second curved region in which the plurality of apertures is formed, the second curved region being curved in two dimensions;
the first curved region and second curved region face each other to form a gap having a substantially constant width; and
the second electrode has a third electrode surface on the opposite side to the second electrode surface and the third electrode surface is substantially planar.

According to an aspect of the invention there is provided a charged particle-optical device configured to direct a plurality of charged particle beams along respective beam paths towards a sample location, the charged particle-optical device comprising the charged particle-optical element described above.

According to an aspect of the invention there is provided a charged particle-optical apparatus comprising:
the charged particle-optical device described above;
a source configured to emit the charged particle beams; and
an actuatable stage configured to support a sample at the sample location.

According to an aspect of the invention there is provided a method of manufacturing an electrode for a charged particle-optical element, the method comprising:
providing a substrate having a concave surface;
directing a plurality of charged particle beams onto the concave surface such that the charged particle beams are incident substantially normally; and
etching the substrate at the locations where the charged particle beams are incident.

According to an aspect of the invention there is provided a charged particle-optical element comprising a first electrode and a second electrode, each having a plurality of apertures configured and arranged for passing individual beamlets of a beam grid array through the charged particle-optical element, wherein:
the first electrode has a first interior surface and the second electrode has a second interior surface, the first and second interior surfaces facing each other;
the first electrode has a first exterior surface and the second electrode has a second exterior surface, the first and second interior surfaces facing away from each other;
the first interior surface has a first curved region in which the plurality of apertures is formed, the first curved region being curved in two dimensions;
the second interior surface has a second curved region in which the plurality of apertures is formed, the second curved region being curved in two dimensions;
the first curved region and second curved region form a gap having a substantially constant width; and
the second exterior surface is substantially planar.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts a charged particle-optical device array;
- Figure 5 schematically depicts a collimator array of an embodiment in perspective view;
- Figure 6 is a schematic cross-section of the collimator array of Figure 5;
- Figure 7 is a schematic cross-section of the collimator array of Figure 5 showing a mounting arrangement;
- Figure 8 is a schematic cross-section of the collimator array of Figure 5 showing an alternative mounting arrangement;
- Figure 9 schematically depicts a method of forming apertures in an embodiment;
- Figure 10 schematically depicts another method of forming apertures in an embodiment;
- Figure 11 schematically depicts another method of forming apertures in an embodiment;
- Figure 12 schematically depicts an illumination arrangement for methods of forming directed apertures in embodiments; and
- Figures 13 to 17 schematically depict steps in another method for forming apertures in embodiments.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

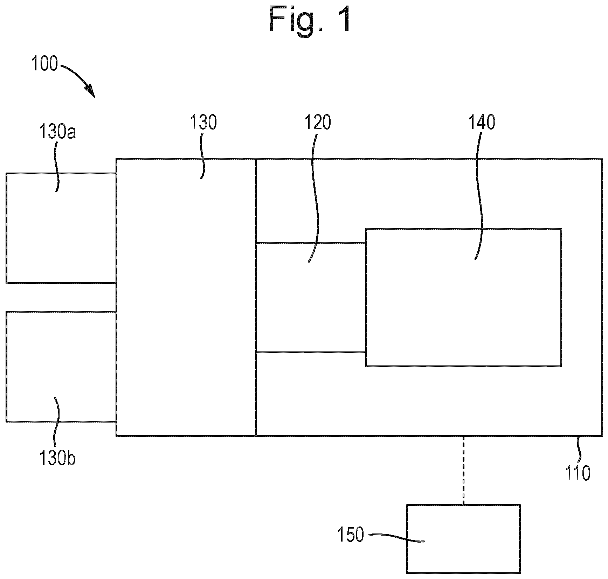

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample can be generated. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a high throughput of sample assessment may be achieved using a multibeam assessment apparatus than a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

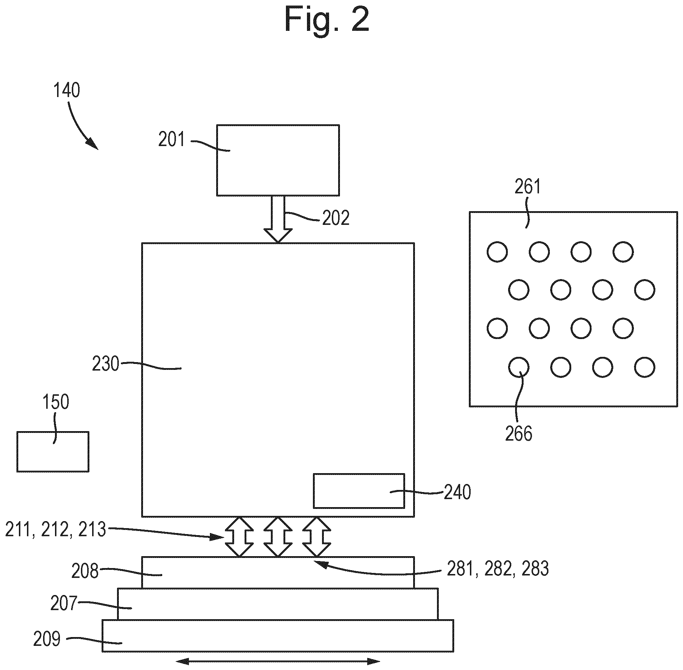

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example 20,000 or more per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208 which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, he detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

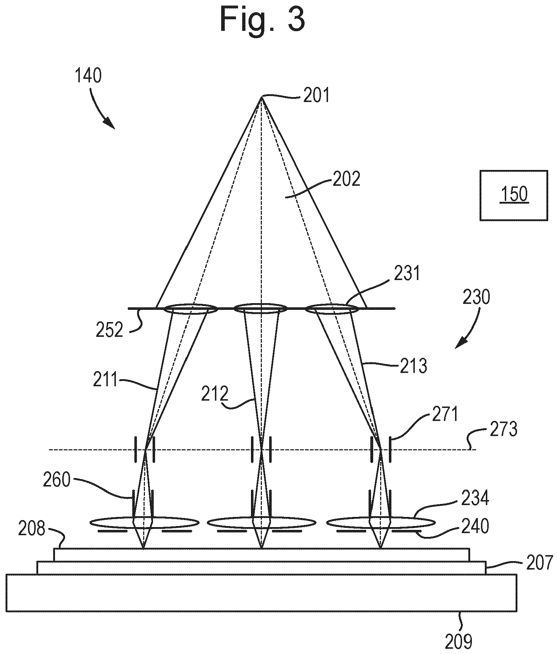

Figure 3 schematically depicts an embodiment of an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 234 and the detector array 240.

The source 201 generates a diverging source beam 202. The beam limiting aperture array 252 defines a plurality of primary beams 211, 212, 213 from the source beam 202. In the current embodiment, the condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Although not shown in Figure 3, in an alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 234. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 234.

The objective lens array 234 is configured to focus the primary beams 211, 212, 213 onto the sample 208. The objective lens array 234 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 234 may be proximate the sample 208.

The stack of plates 261 of the objective lens array 234 may be referred to as, or as part of, an objective lens assembly. The objective lens assembly may comprise one or more of the scan deflector array 260, a corrector array (not shown) and the detector array 240 in addition to the objective lens array 234. The objective lens assembly may comprise additional plates having lens functionality providing additional degrees of electron-optical freedom. A control lens array may be comprised by such an additional plate.

In an embodiment the detector array 240 may be integrated into the objective lens array 234. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 234.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 234, or between two of these arrays, e.g. between the condenser lens array and the collimator array.

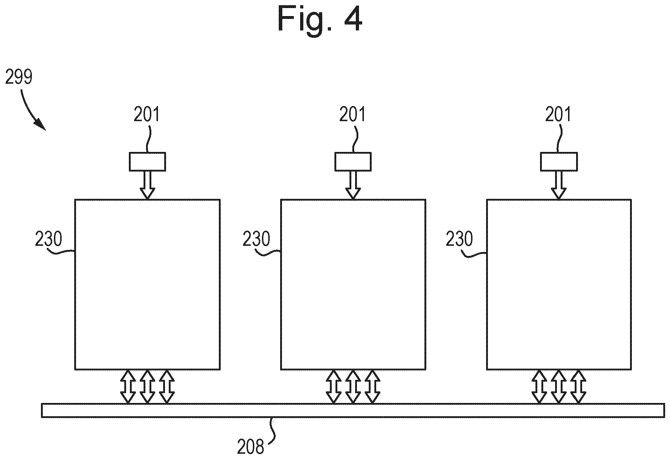

Figure 4 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

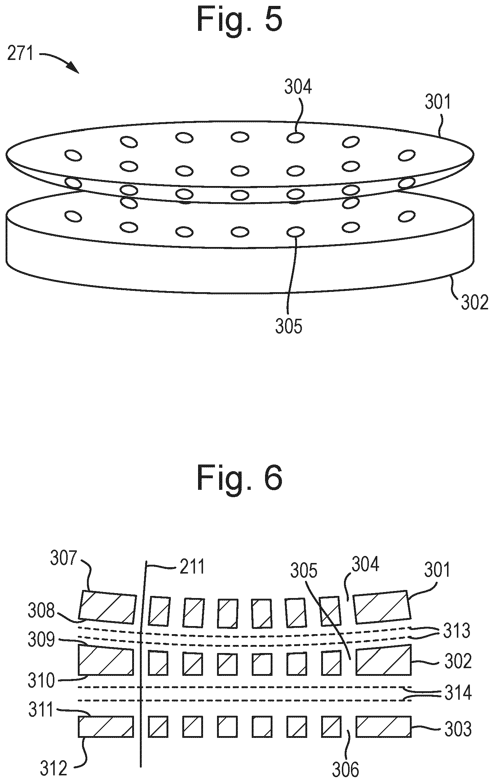

Figures 5 to 8 depict a charged particle element of an embodiment of the invention comprising first curved electrode 301 and second curved electrode 302 and, optionally a further, planar electrode 303. The curved electrodes are curved in two dimensions. The charged particle element may function as a collimator array 271. The first and second curved electrodes 301, 302 and, if present, planar electrode 303 are provided with respective pluralities of apertures 304, 305, 306 to allow passage through the collimator array of a grid of charged-particle beamlets 211. The charged-particle beamlets 211 follow respective beam paths that are mutually divergent from a source toward the collimator array 271. The collimator array is configured so that, when the electrodes 301- 303 are connected to appropriate voltage sources, the charged particle beamlets 211 are mutually collimated as they pass through the beam passages defined by apertures 304, 305, 306. In other words, in use, the charged particle beamlets 211 are redirected by the collimator array so that they are substantially parallel.

Compared to a collimator arrangement of two pairs of electrodes each curved in one direction, the use of two electrodes each curved in two directions, simplifies assembly and alignment of the collimator arrangement. The collimator arrangement can also be made more compact. Avoiding continuous mechanical stress in the electrodes enables more accurate curvatures to be maintained. A mechanically stressed electrode may be subject to creep.

Collimator array 271 of Figures 5 to 8 may be employed in the charged particle-optical device of Figure 3, as described above. It may also be used in other charged particle-optical devices, especially charged particle-optical devices having a large number of beams and/or a high proportion of components formed by MEMS techniques. The first and second curved electrodes 301, 302 and, if present, planar electrode 303 may be referred to collectively as a collimator array stack.

The inner surfaces of the first and second curved electrodes have two-dimensionally curved regions that face each other. Specifically, the first electrode (uppermost in Figures 5 and 6) 301 has on its lower surface (referred to herein as a first electrode surface) a first curved region 308. The second electrode 302 has on its upper surface (referred to herein as a second electrode surface) a second curved region 309. The first curved region 308 faces the second curved region 309. The first curved region 308 and second curved region 309 are configured so as to create, when connected to a voltage source (not shown), a field having curved equipotential surfaces 313 so as to redirect the beams 211 from mutually diverging beam paths to parallel beam paths. The first curved region 308 and the second curved region 309 are desirably concentric. The first curved region 308 and the second curved region 309 are desirably substantially spherical, that is each conforms to part of a virtual spherical surface. The gap between the first curved region 308 and the second curved region 309 desirably has a constant width. The radii of curvature of the first curved region and the second curved region may be less than 100 mm.

The upper surface (referred to herein as a third electrode surface) of first electrode 301 has a third curved region 307. Third curved region 307 is configured so that it is generally perpendicular to the diverging incident beams 211. Third curved region 307 may be a substantially spherical surface having a radius of curvature that is smaller than a distance to a (virtual) source of the beams 211. Third curved region 307 has a larger radius of curvature (less strongly curved) than the first curved region.

The lower surface (referred to herein as a fourth electrode surface) of second electrode 302 has a planar region 310. It will be appreciated that planar region 310 is perpendicular to the collimated beams 211.

The lower surface of the first electrode and the upper surface of the second electrode may be referred to as interior surfaces since they face each other. The upper surface of the first electrode and lower surface of the second electrode may be referred to as exterior surfaces since they face away from each other.

A potential difference applied between the first and second electrode 301, 302 to cause the collimation of the beams 211 will affect the energy of the charged-particle beams. A third electrode 303 may be provided to control the energy of the beams emitted from the collimator array 271. Desirably, the third electrode 303 is connected to the same potential as the first electrode so that there is no net acceleration or deceleration of the charged particle beams. The third electrode 303 is planar and parallel to the lower surface of second electrode 302. Top surface 311 and bottom surface 312 of planar electrode 303 are desirably flat and parallel. The gap between the lower surface of second electrode 302 and the third electrode 303 desirably has a constant width. Equipotential surfaces 314 between second electrode 302 and third electrode 303 are flat.

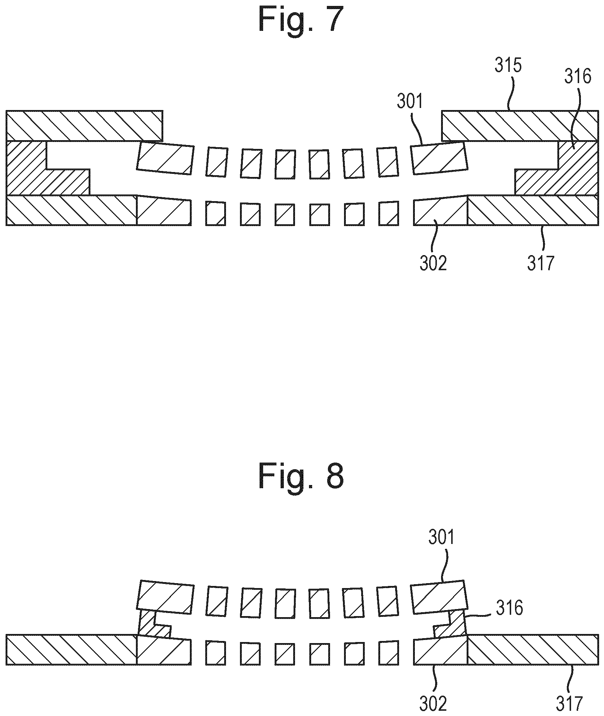

Figures 7 and 8 depict two options for mounting the first electrode 301 and second electrode 302. In the arrangement of Figure 7, first electrode 301 is mounted to a mounting bracket 315, e.g. by welding or adhesive. The curved portion of lower electrode 302 is integrally formed with a flat peripheral portion 317, or may be mounted in a support ring. Stepped spacer 316 is provided between the mounting bracket 315 and peripheral portion 317 in order to define and maintain the correct spacing between first electrode 301 and second electrode 302. The shape of stepped spacer 316 is determined in order to minimize the risk of flashover discharge. Stepped spacer 316 may be formed of any suitable insulating material. In an embodiment in which the potential difference between the first electrode 301 and the second electrode 302 is relatively low, the spacer 316 may not be a stepped spacer 316, but may have a straight connection (not shown) between the mounting bracket 315 and the peripheral portion 317.

The arrangement of Figure 8 differs in that a stepped spacer 316 is provided directly between curved portions of first electrode 301 and second electrode 302 and no mounting bracket on first electrode 301 is required. The assembly of first electrode 301 and second electrode 302 may be mounted into the electron-optical device via the peripheral portion 317 of the second electrode 302. Similar mounting approaches may be used for the optional third electrode 303.

First electrode 301 and second electrode 302 are desirably formed from a conductor, such as copper. The electrodes may also be made of insulating material or a semiconductor, such as silicon, coated with a conductive coating. In an embodiment, the first electrode 301 and second electrode 302 may have a diameter of order 100 mm to 500 mm and a thickness order 0.1 mm to 2 mm. The required curvatures of the first, second and third curved regions may be obtained by conventional lens forming and polishing techniques. The range of curvatures and degree of precision required is similar to that required for optical devices.

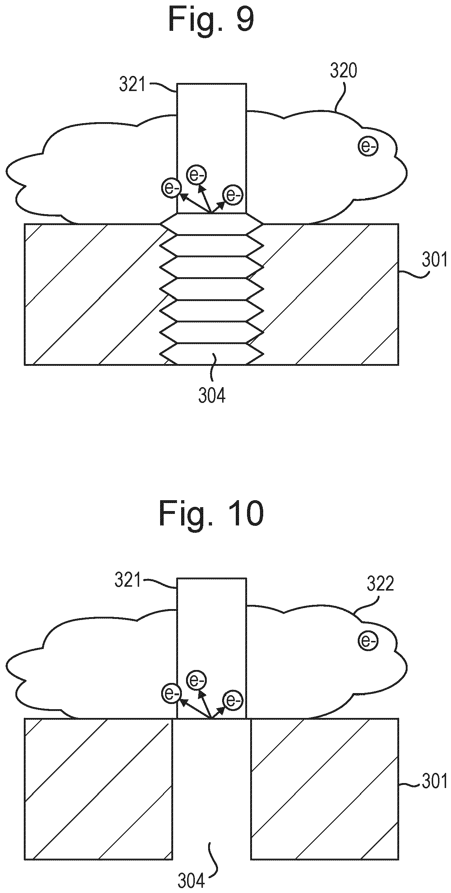

Various different techniques may be employed to form the apertures 304 in the first electrode 301, as will be described with reference to Figures 9 to 12. Apertures 304 in first electrode 301 desirably extend radially from the center of curvature of the first and second curved regions. In other words, apertures 304 extend perpendicular to the surface of the first and second curved regions. The appropriate direction of each of the apertures 304 may be achieved using a charged particle beam, e.g. an electron beam.

A first approach is schematically depicted in Figure 9. A reactive agent 320 is provided in the vicinity of the first electrode 301. An electron beam 321 activates the active agent 320 to form a plasma and locally modifies the material structure of first electrode 301. Secondary electrodes emitted by the first electrode 301 may also contribute to activation of the plasma. The reactive agent 320 in plasma state selectively etches the material of the first electrode 301 that has been modified by the electron beam 321. The steps of irradiating the electron beam and etching may be alternated, resulting in aperture 304 having undulating side walls. Shorter irradiation and etching steps may result in less undulation but require more time to complete formation of the apertures 304. A suitable balance between smoothness of the side walls and speed of formation can be determined, e.g. by trial and error. This approach is particularly suitable where the first electrode is formed of copper or diamond. More details of such a process are disclosed in US9520294B2.

A second approach is schematically depicted in Figure 10. In this approach, a reactive agent 322 is activated by electrons in an e-beam 321 and secondary electrons emitted from the first electrode response to the electron beam 321. Aperture 304 is formed in a slow continuous plasma etching process fueled by the secondary electrons and electrons from the e-beam. This approach provides smoother walls than the first approach but may be slower. The methods disclosed in "Focused electron beam induced etching of silicon by chlorine gas: Negative effects of residual gas contamination on the etching process I Journal of Applied Physics" https://doi.org/10.1063/1.3525587 and "Electron beam directed etching of hexagonal boron nitride" https://doi.org/10.1039/C6NR04959A may be adapted to this approach.

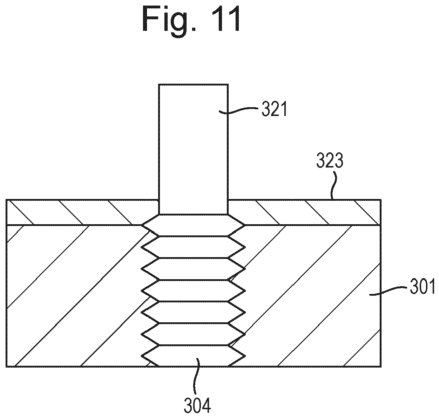

A third approach is schematically depicted in Figure 11. The first electrode 301 is coated with an e-beam resist 323 which is locally exposed by e-beam 321, developed and the developed portions removed. The resist may be applied by spin coating or spraying. A Bosch-etch process is performed to etch the apertures perpendicular to the surface. The Bosch-etch process, which may also be referred to as deep reactive ion etching (DRIE), comprises alternating steps of a nearly isotropic plasma etch and deposition of a chemically inert passivation layer. Each step lasts for several seconds. The passivation layer protects the substrate from further chemical attack and prevents further etching. However, during the etching phase, the ions that bombard the substrate attack the passivation layer at the bottom of the hole by sputtering, exposing the underlying substrate to the chemical etchant. As in the approach described above with reference to Figure 9, this approach may result in the side walls of the apertures having undulations. A trade-off between smoothness of the aperture walls and speed can be achieved by varying the cycle time of the etch and deposition steps. This approach is particularly appropriate if the first electrode 301 is formed from a silicon substrate.

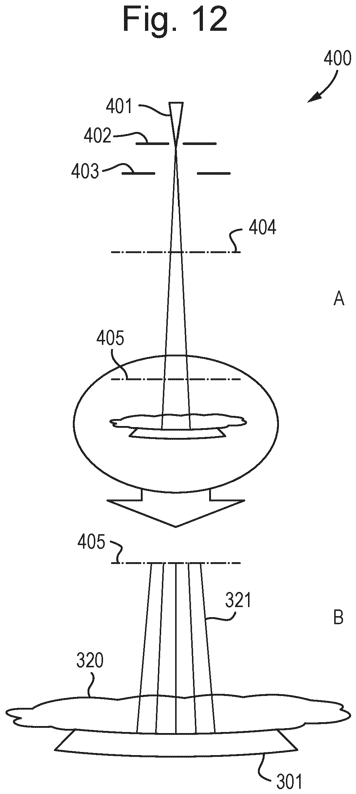

Figure 12 schematically depicts an illumination arrangement that can create directional e-beams for use in the methods described above with reference to Figures 9 to 11. In Figure 12, part B is enlargement of the portion in part A indicated by an ellipse. Electrodes 402, 403 accelerate electrons from a cathode 401 towards an aperture 404 and a beam limiting array 405. Beam limiting array 405 defines the electron beams 321 which irradiate the first electrode 301 through reactive agent 320. The geometry of the cathode 401 and beam limiting array 405 are arranged to correspond to the geometry of the electron optical column in which the finished assembly will be used so that the beams 321 have the appropriate direction and spacing. A similar arrangement may be used with ion-beams. As an alternative, a single e-beam or ion-beam could be used with the electrode being moved and angled appropriately to form each aperture.

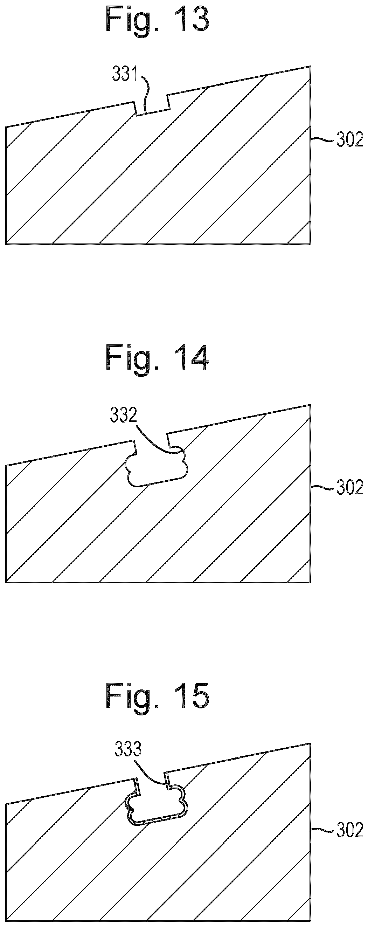

Figures 13 to 17 schematically depict steps in a process for creating the second electrode 302. Only one aperture is shown in the figure but it will be understood that all required apertures can be formed simultaneously. The apertures 305 (see Fig. 6) are desirably perpendicular to the planar bottom surface of second electrode 302 so that conventional techniques for manufacturing through holes can be used. However, it is desirable that the entrance to the apertures in the upper, curved surface (the second curved region) of second electrode 302 are correctly formed. The position and shape (ellipticity) of the upper entrances to the apertures affect the shape and direction of the electron beams that pass through them. The following method can be used to achieve sufficiently accurate formation of the apertures.

As depicted in Figure 13, initial recesses 331 are formed in the appropriate locations in the second curved region using the methods described above with reference to Figure 11. That is, a resist mask is created and a Bosch-etch process used to create an aperture extending perpendicular to the curved surface. This produces the situation shown in Figure 13, a shallow recess 331 extending into the body of the second electrode 302 by a small distance. Desirably, the depth of the recess is approximately twice its diameter so that the effect of the shape of the hole on the electron beam is reduced.

The next step, depicted in Figure 14 is to perform an isotropic etch of a longer duration to create an enlarged chamber 332 that is wider than the initial recess.

As depicted in Figure 15, a stop layer 333 is then created to line the enlarged chamber 332. In the case of a silicon substrate, the stop layer 333 can be formed by oxidizing the silicon to form a layer of Si₂O₃.

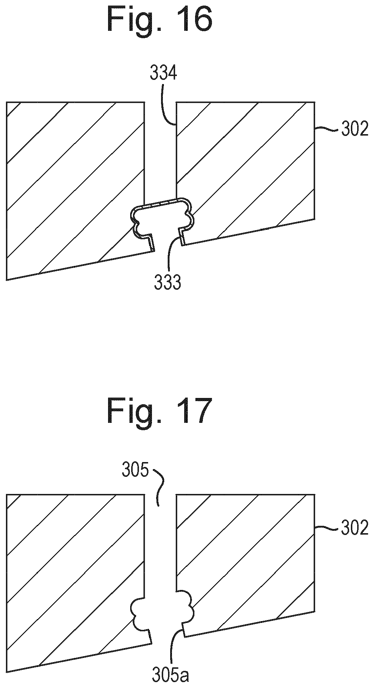

The substrate is now inverted and a directional etch perpendicular to the planar lower surface of the second electrode 302 is performed until the stop layer is reached. This creates a channel 334 perpendicular to the planar surface of the second electrode 302 as depicted in Figure 16. Finally, the stop layer is removed so as to create a through hole 305 with an accurately defined opening 305a in the curved region of second electrode 302 as depicted in Figure 17.

The charged particle-optical element of the invention is described above as used to collimate a plurality of charged particle beams. It may also be used in a reverse configuration, that is to redirect a plurality of parallel charged-particle beams into converging beam paths. This may be useful, e.g., to reduce the size of a grid of beams. The charged particle-optical element of the invention may also be configured to collimate converging beams or diverge parallel beams

In an embodiment any electron-optical element or group of electron-optical elements may be replaceable or field replaceable within the electron-optical apparatus 140. Field replaceability means that the electron-optical element or group of electron-optical elements may be replaced without substantially disassembling the electron-optical apparatus 140. In an embodiment the electron-optical apparatus 140 comprises at least one module. Each module comprises a group of adjacent electron-optical elements. The electron-optical elements of a module may be secured to each other, for example as a stack.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Embodiments of the invention are described in the following numbered clauses.

Clause 1. A charged particle-optical element comprising a first electrode and a second electrode, each having a plurality of apertures configured and arranged for passing individual beamlets of a beam grid array through the charged particle-optical element, wherein
the first electrode has a first electrode surface having a first curved region in which the plurality of apertures is formed, the first curved region being curved in two dimensions;
the second electrode has a second electrode surface having a second curved region in which the plurality of apertures is formed, the second curved region being curved in two dimensions;
the first curved region and second curved region face each other to form a gap having a substantially constant width; and
the second electrode has a third electrode surface on the opposite side to the second electrode surface and the third electrode surface is substantially planar.

Clause 2. A charged particle-optical element according to clause 1 wherein the first curved region and the second curved region are substantially spherical.

Clause 3. A charged particle-optical element according to clause 1 wherein the first curved region and the second curved region are substantially concentric.

Clause 4. A charged particle-optical element according to clause 3 wherein the radii of curvature of the first curved region and the second curved region are less than 100 mm.

Clause 5. A charged particle-optical element according to clause 1, 2, 3 or 4 wherein the first electrode has a fourth electrode surface on the opposite side to the first electrode surface, wherein the fourth electrode surface has a third curved region.

Clause 6. A charged particle-optical element according to clause 5 wherein the radius of curvature of the third curved region is larger than the radius of curvature of the first curved region.

Clause 7. A charged particle-optical element according to clause 5 or 6 wherein the first curved region is convex and the third curved region is concave.

Clause 8. A charged particle-optical element according to clause 5, 6 or 7 wherein the plurality of apertures in the first electrode extend in directions substantially perpendicular to the third curved region.

Clause 9. A charged particle-optical element according to any of the preceding clauses further comprising a third electrode having a plurality of apertures configured and arranged for passing individual beamlets of a beam grid array through the charged particle-optical element, wherein the third electrode is substantially planar and faces the third electrode surface.

Clause 10. A charged particle-optical element according to any of the preceding clauses wherein the plurality of apertures in the second electrode extend in directions substantially perpendicular to the third electrode surface.

Clause 11. A charged particle-optical element according to any of the preceding clauses wherein the first electrode and the second electrode are formed of silicon.

Clause 12. A charged particle-optical element according to any of the preceding clauses wherein the plurality of apertures in the first electrode and the second electrode have been formed by directed etching.

Clause 13. A charged particle-optical device configured to direct a plurality of charged particle beams along respective beam paths towards a sample location, the charged particle-optical device comprising the charged particle-optical element according to any of the preceding clauses.

Clause 14. A charged particle-optical device according to clause 13 wherein the charged particle-optical element is oriented such that the first electrode is upbeam along the respective beam paths.

Clause 15. A charged particle-optical apparatus comprising:
the charged particle-optical device of clause 13 or 14;
a source configured to emit the charged particle beams; and
an actuatable stage configured to support a sample at the sample location.

Clause 16. A method of manufacturing an electrode for a charged particle-optical element, the method comprising:
providing a substrate having a concave surface;
directing a plurality of charged particle beams onto the concave surface such that the charged particle beams are incident substantially normally; and
etching the substrate at the locations where the charged particle beams are incident.

Clause 17. A method according to clause 16 wherein the charged particle beams are incident on the substrate in the presence of a reactive agent such that the material of the substrate is locally modified and the etching is selective for the modified material.

Clause 18. A method according to clause 16 wherein the charged particle beams are incident on the substrate in the presence of a reactive agent such that reactive agent is activated by the charged particle beam to perform the etching.

Clause 19. A method according to clause 16 wherein the substrate is provided with a resist and the charged particle beams expose the resist, whereby the etching progresses only where the resist has been exposed.

Clause 20. A method according to clause 19 wherein the etching is a directional pulsed etching process.

Clause 21. A method according to clause 16 wherein the etching comprises a first etch phase which is directional to form recesses extending substantially perpendicular to the concave surface and a second etch phase that is isotropic to form enlarged chambers below the concave surface; and the method further comprises a second etching from a side of the substrate opposite the concave surface to form through-holes reaching the enlarged chambers.

Clause 22. A charged particle-optical element comprising a first electrode and a second electrode, each having a plurality of apertures configured and arranged for passing individual beamlets of a beam grid array through the charged particle-optical element, wherein:
the first electrode has a first interior surface and the second electrode has a second interior surface, the first and second interior surfaces facing each other;
the first electrode has a first exterior surface and the second electrode has a second exterior surface, the first and second interior surfaces facing away from each other;
the first interior surface has a first curved region in which the plurality of apertures is formed, the first curved region being curved in two dimensions;
the second interior surface has a second curved region in which the plurality of apertures is formed, the second curved region being curved in two dimensions;
the first curved region and second curved region form a gap having a substantially constant width; and
the second exterior surface is substantially planar.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

### List of reference numerals:

100 assessment apparatus
110 vacuum chamber (main chamber)
120 load lock chamber
130 EFEM
130a first loading port
130b second loading port
140 electron-optical apparatus (electron beam apparatus, electron apparatus)
150 controller
201 source
202 source beam
207 sample holder
208 sample
209 actuatable stage
211, 212, 213 primary beams (sub-beams, beamlets)
230 electron-optical device (electron-optical column)
231 condenser lens array
234 objective lens array
240 detector array
252 beam limiting aperture array
260 deflector array
261 plate
266 beam aperture
271 collimator array
273 intermediate focus plane
281, 282, 283 probe spots
299 electron-optical device array
301 first electrode
302 second electrode
303 third electrode
304, 305, 306 aperture
305a opening
307 third curved region
308 first curved region
309 second curved region
310 planar region
311 top surface
312 bottom surface
313, 314 equipotential surfaces
315 mounting bracket
316 stepped spacer
317 peripheral portion
320 reactive agent
321 electron beam
322 reactive agent
323 resist
331 recess
332 enlarged chamber
333 stop layer
334 channel
401 electron source
402, 403 electrodes
404 aperture
405 beam limiting array

## Claims

1. A charged particle-optical element comprising a first electrode and a second electrode, each having a plurality of apertures configured and arranged for passing individual beamlets of a beam grid array through the charged particle-optical element, wherein
the first electrode has a first electrode surface having a first curved region in which the plurality of apertures is formed, the first curved region being curved in two dimensions;
the second electrode has a second electrode surface having a second curved region in which the plurality of apertures is formed, the second curved region being curved in two dimensions;
the first curved region and second curved region face each other to form a gap having a substantially constant width; and
the second electrode has a third electrode surface on the opposite side to the second electrode surface and the third electrode surface is substantially planar.

2. A charged particle-optical element according to claim 1 wherein the first curved region and the second curved region are substantially spherical.

3. A charged particle-optical element according to claim 1 wherein the first curved region and the second curved region are substantially concentric.

4. A charged particle-optical element according to claim 3 wherein the radii of curvature of the first curved region and the second curved region are less than 100 mm.

5. A charged particle-optical element according to claim 1, 2, 3 or 4 wherein the first electrode has a fourth electrode surface on the opposite side to the first electrode surface, wherein the fourth electrode surface has a third curved region.

6. A charged particle-optical element according to claim 5 wherein the radius of curvature of the third curved region is larger than the radius of curvature of the first curved region.

7. A charged particle-optical element according to claim 5 or 6 wherein the first curved region is convex and the third curved region is concave.

8. A charged particle-optical element according to claim 5, 6 or 7 wherein the plurality of apertures in the first electrode extend in directions substantially perpendicular to the third curved region.

9. A charged particle-optical element according to any of the preceding claims further comprising a third electrode having a plurality of apertures configured and arranged for passing individual beamlets of a beam grid array through the charged particle-optical element, wherein the third electrode is substantially planar and faces the third electrode surface.

10. A charged particle-optical element according to any of the preceding claims wherein the plurality of apertures in the second electrode extend in directions substantially perpendicular to the third electrode surface.

11. A charged particle-optical element according to any of the preceding claims wherein the first electrode and the second electrode are formed of silicon.

12. A charged particle-optical element according to any of the preceding claims wherein the plurality of apertures in the first electrode and the second electrode have been formed by directed etching.

13. A charged particle-optical device configured to direct a plurality of charged particle beams along respective beam paths towards a sample location, the charged particle-optical device comprising the charged particle-optical element according to any of the preceding claims.

14. A charged particle-optical device according to claim 13 wherein the charged particle-optical element is oriented such that the first electrode is upbeam along the respective beam paths.

15. A charged particle-optical apparatus comprising:
the charged particle-optical device of claim 13 or 14;
a source configured to emit the charged particle beams; and
an actuatable stage configured to support a sample at the sample location.
